(19) Europäisches Patentamt

European Patent Office

Office européen des brevets

(11) Numéro de publication: **0 327 966 B1**

(12) **FASCICULE DE BREVET EUROPEEN**

(45) Date de publication de fascicule du brevet: **20.10.93** (51) Int. Cl.⁵: **H03H 15/00**, H03H 17/06

(21) Numéro de dépôt: **89101799.8**

(22) Date de dépôt: **02.02.89**

(54) **Filtre transverse.**

(30) Priorité: **09.02.88 FR 8801504**

(43) Date de publication de la demande:
**16.08.89 Bulletin 89/33**

(45) Mention de la délivrance du brevet:
**20.10.93 Bulletin 93/42**

(84) Etats contractants désignés:
**DE ES FR GB IT NL SE**

(56) Documents cités:
**EP-A- 0 209 928**
**FR-A- 2 402 345**

**ARCHIV FÜR ELEKTRONIK UND ÜBERTRA-GUNGSTECHNIK, vol. 25, no. 3, mars 1971, pages 155-159, Stuttgart, DE; P. LEUTHOLD: "Transversalfilter zur Erzeugung von Funktionspaaren, die durch die Hilbert-Transformation verknüpft sind"**

(73) Titulaire: **ALCATEL TELSPACE**
**5, rue Noel Pons**
**F-92734 Nanterre Cédex(FR)**

(72) Inventeur: **De Luca, Olivier**
**9, rue Rouget de Lisle**
**F-92150 Suresnes(FR)**

(74) Mandataire: **Weinmiller, Jürgen et al**
**Lennéstrasse 9**
**Postfach 24**
**D-82336 Feldafing (DE)**

Rank Xerox (UK) Business Services
(3.10/3.6/3.3.1)

**Description**

L'invention concerne un filtre transverse : L'invention est une optimisation de la structure d'un filtre transverse réalisé en fréquence intermédiaire utilisé dans un égaliseur temporel destiné aux faisceaux hertziens numériques.

Les évanouissements sélectifs dus à la propagation par trajets multiple affectent tout particulièrement la transmission par faisceaux hertziens numériques à grande capacité pour lesquels la bande requise par canal est élevée. L'utilisation de modulation multi-états à haute efficacité spectrale permet pourtant de réduire la bande passante nécessaire à la transmission de chaque canal, de façon à optimiser l'utilisation des plans de fréquence. Mais la complexité de ces modulations les rend sensibles aux distorsions. La dégradation de la transmission se traduit par l'apparition d'erreurs d'où une dégradation de qualité, voire dans les cas graves, de la disponibilité de liaison.

Divers remèdes peuvent être proposés :

- Diversité de fréquence : c'est la commutation d'un canal perturbé sur un canal redondant appelé secours. Elle est malheureusement insuffisante quand plusieurs canaux sont perturbés simultanément ;
- Diversité d'espace qui peut être :
  * diversité à maximum de puissance ;
  * diversité à minimum de distorsion ;
  * diversité par commutation en bande de base.

  Performante (tout en étant limitée à la correction de troubles dus à la propagation), la diversité d'espace est coûteuse en antenne et par la même, en emplacement sur les tours hertziennes ;
- Egalisation auto-adaptative en bande de base qui est un traitement complet du signal (amplitude et phase) et dont les possibilités s'étendent au delà de la correction des évanouissements sélectifs dûs aux trajets multiples. Une telle égalisation est décrite dans un article intitulé "Egaliseurs auto-adaptatifs en bande de base pour faisceaux hertziens numériques" de O. de Luca dans la revue Technique Thomson-CSF vol. 16, n° 1, de mars 1984 ;
- Egalisation auto-adaptative en fréquence intermédiaire. Contrairement à l'égalisation en bande de base, on traite simultanément les deux voies en quadrature ce qui permet d'obtenir des structures moins lourdes, et donc moins coûteuses pour des réalisations analogues.

Un égaliseur de ce type, basé sur le principe du filtre transverse, permet de corriger les distorsions subies par le signal, dues notamment aux trajets multiples.

L'invention a pour objet de réaliser une optimisation de la structure d'un filtre transverse réalisé en fréquence intermédiaire et utilisé dans un égaliseur temporel.

Elle propose à cet effet un filtre transverse comportant $M+L+1$ branches comprenant chacune, de part et d'autre d'un point milieu un premier multiplieur par un premier coefficient et un second multiplieur par un second coefficient, chaque branche étant reliée à ses deux extrémités respectivement à un premier sommateur et à un second sommateur, et $M+L$ cellules de retard en série, chacune d'elle étant reliée au point milieu de l'une des branches, caractérisé en ce qu'un déphaseur large bande, dont le déphasage $\Delta\phi$ tel que $\Delta\phi = \Omega_0 T$ (modulo $2\pi$), où $\Omega_0$ est la pulsation porteuse en fréquence intermédiaire et $T$ représente la durée du retard dû à une cellule retard, est associé en série avec chaque cellule retard, avantageusement de valeur $T = T_s$, où $T_s$ représente la durée d'un symbole.

Dans une seconde réalisation l'invention propose un filtre dans lequel chaque cellule retard est reliée au point milieu d'une branche d'indice $i$ par un déphaseur dont la valeur de déphasage est $i\Delta\phi$ avec $-M \leq i \leq +L$.

Avantageusement on réalise un filtre tel que $M = L = 2$, lorsque $\Omega_0 T_s = -\pi/2$, la branche d'indice -2 ayant un premier coefficient $-C_{p-2}$ et un second coefficient $-C_{q-2}$ ; la branche d'indice -1 un premier coefficient $-C_{q-1}$ et un second coefficient $C_{p-1}$ ; la branche d'indice +1 un premier coefficient $C_{q+1}$, et un second coefficient $-C_{p+1}$ ; et la branche d'indice +2 un premier coefficient $-C_{p+2}$ et un second coefficient $-C_{q+2}$.

Les caractéristiques et avantages de l'invention ressortiront d'ailleurs de la description qui va suivre, à titre d'exemple non limitatif, en référence aux figures annexées sur lesquelles :

- la figure 1 représente une structure de filtre transverse de l'art connu ;
- la figure 2 représente une première réalisation du filtre transverse selon l'invention ;
- la figure 3 représente une seconde réalisation du filtre transverse selon l'invention ;
- la figure 4 représente un cas particulier du filtre transverse représenté en figure 3 .
- la figure 5 représente une autre réalisation du filtre transverse de l'invention.

Un filtre transverse permet de modifier le signal par une combinaison pondérée de ce signal pris à différents instants, espacés successivement d'un temps $T$.

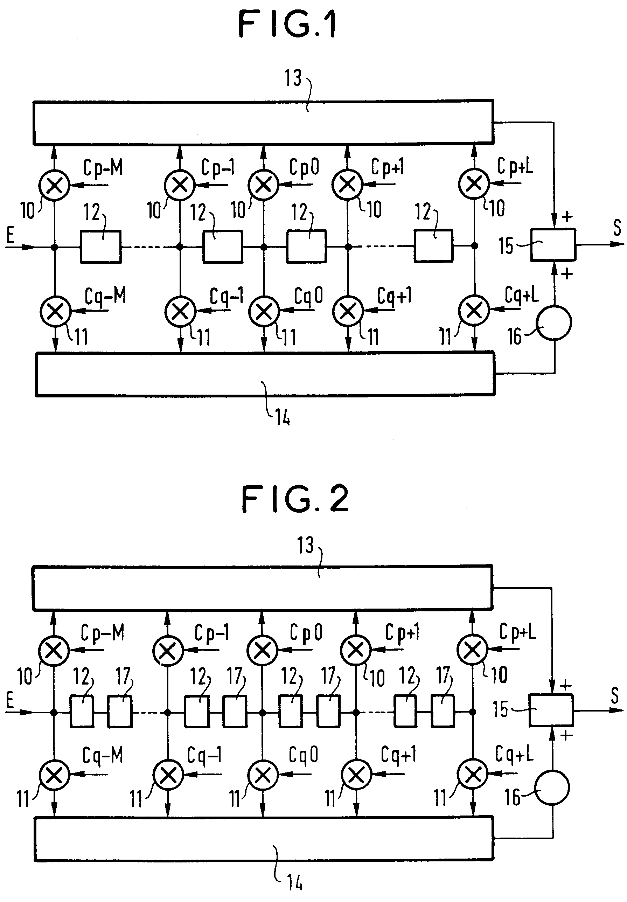

En effet un tel filtre, représenté à la figure 1, a un coefficient central Co, M coefficients complexes dits "avant" (indices de -M à -1) servant à corriger la partie avant de la réponse impulsionnelle, et L coefficients dits "arrière" (indices de +1 à +L) servant à corriger la partie arrière de la réponse impulsionnelle.

Ce filtre transverse de l'art connu comporte M + L + 1 branches d'indices i avec -M ≤ i ≤ +L, soient :

- une branche centrale d'indice 0 ;
- L branches d'indices positifs +1 à +L ;
- M branches d'indices négatifs -1 à -M;

chaque branche comprenant de part et d'autre d'un point milieu un premier multiplieur 10 par un coefficient $Cq_i$ correspondant à la partie du signal en phase, et un second multiplieur 11 par un coefficient $Cp_i$ correspondant à la partie du signal en quadrature de phase.

Ce filtre comporte de plus M + L cellules retard 12 en série dont la première reçoit le signal d'entrée E, chaque cellule retard 12 étant disposée entre les points milieux de deux branches voisines.

Les premiers multiplieurs 10 ont leur seconde extrémité reliée à une entrée d'un premier sommateur 13, les seconds multiplieurs 11 ont leur seconde extrémité reliée à une entrée d'un second sommateur 14, la sortie du premier sommateur étant reliée directement à une première entrée d'un troisième sommateur 15, la sortie du second sommateur étant reliée à une seconde entrée de ce troisième sommateur 15 au travers d'un déphaseur 16 par $\pi/2$, La sortie de ce troisième sommateur étant la sortie S dudit filtre sur laquelle on obtient un signal somme pondéré du signal d'entrée E retardé successivement dans M + L cellules à retard T

Si on considère les données suivantes :

* $C_k = Cp_k + jCq_k$ le coefficient complexe de rang k du filtre transverse. Le filtre transverse possède un coefficient central $C_0$ tel que $C_0 = Cp_0 + jCq_0$, M coefficients dits avant (de -M à -1) et L coefficients dits arrière (de +1 à +L).

* $Ze(t) = Xe(t) + jYe(t)$ le signal bande de base émis (avant filtrage), à l'instant t ;

* $Sr(t) = (Xr(t) + jYr(t)).EXP(j\,\Omega_0 t) = Zr(t).EXP(j\,\Omega_0 t)$ le signal présent à la réception, à l'instant t, au niveau du coefficient $c_0$ du filtre transverse, réalisé en fréquence intermédiaire, représenté sur la figure 1, $\Omega_0$ étant la pulsation porteuse en fréquence intermédiaire (Pour la simplicité de l'écriture des équations, on omet de représenter ici le décalage temporel entre émission et réception, ce qui ne restreint pas la généralité du propos).

Le signal à la sortie du filtre transverse s'écrit :

$$Sc(t) = \sum_{k=-M}^{+L} C_k . Sr(t-kT) = Xc(t) + j\,Yc(t)$$

où T est un retard fixe usuellement pris égal au temps symbole Ts puis

$$Sc(t) = EXP(j\,\Omega_0 t).\sum_{k=-M}^{+L} C_k . Zr(t-kT).EXP(-jk\,\Omega_0 T)$$

$$\text{Soit } Zc(t) \text{ la quantité } \sum_{k=-M}^{+L} C_k . Zr(t-kT).EXP(-jk\,\Omega_0 T)$$

qui constitue la représentation complexe bande de base du signal reçu égalisé.

Le calcul des coefficients $C_k$ qui permettra la meilleure réception possible du signal émis est réalisé suivant un algorithme dérivé de l'algorithme du gradient pour k variant de -M à +L :

$$C_k^{i+1} = C_k^i - \mu.E_i.Ze_{i-k}{}^* EXP(jk\,\Omega_0 T) \text{ pour k variant de -M à +L}$$

ou :

* $C_k^i$ est le coefficient complexe de rang k pris à l'instant $t = iT_s$ ;
* $\mu$ est le pas de l'algorithme (constant) ;
* $E_i = Ep_i + j.Eq_i$ est le signal d'erreur complexe à l'instant $t = i.T_s$ (on a $E_i = Zc(t=i.T)-Ze(t=i.T)$) ;

$\quad$ * $Ze_{i-k}{}^*$ est le complexe conjugué du signal émis à l'instant $t = (i-k).T_s$

soit maintenant $D_i = Xc(t = i.T_s) + j\hat{Y}c(t = i.T_s)$ le signal régénéré, le symbole $\wedge$ représentant la décision prise lors de la régénération. Lorsque l'égalisation est faite correctement, le signal régénéré à la réception aux instants caractéristiques est égal au signal émis :

$D_i = Ze(t = i.T_s)$.

Il est usuel de modifier l'algorithme donnant $C_k{}^{i+1}$ en

$C_k{}^{i+1} = C_k{}^i - \mu.\hat{E}_i.D_{i-k}{}^* \, EXP(jk\Omega_0 T)$
où $\hat{E}_i = Zc(t = i.T_s)-D_i$

puis en :

$C_k{}^{i+1} = C_k{}^i - \mu .sgn(\hat{E}_i).sgn(D_{i-k}{}^*.EXP(jk\Omega_0 T))$

où $sgn(a + j.b) = sgn(a) + j.sgn(b)$ pour a et b réels (avec $sgn(a)$ = signe de a).

Il apparaît que les termes en $EXP(jk \, \Omega_0 T)$ compliquent la mise en oeuvre pratique de l'algorithme.

Les égaliseurs couramment réalisés dans le domaine des faisceaux hertziens sont des égaliseurs synchrones pour lesquels $T = Ts$, où Ts représente la durée d'un symbole.

Un premier moyen de simplifier $EXP(jk\Omega_0 T)$ consiste à faire en sorte que $\Omega_0 T = \Omega_0 Ts = N.2 \, \pi$ où N est un entier arbitraire. Un exemple de réalisation est décrit dans l'article intitulé : "6GHz 135 MBPS digital radio system with 64 QAM modulation" de T. Noguchi, T. Ryu, Y Koizumi, S. Mizoguchi, M. Yoshimoto, K. Nakamura publié dans ICC 1983, pages 1472 à 1477, dans lequel le débit tramé 6/Ts est ajusté pour satisfaire la relation $\Omega_0 Ts = 6.\pi$ . On a alors $EXP(jk \, \Omega_0 T) = 1$ pour toutes les valeurs de k, ce qui simplifie l'algorithme $C_k{}^{i+1}$ pour donner :

$C_k{}^{i+1} = C_k i- \mu.sgn(\hat{E}).sgn(D_{i-k}{}^*)$

Un second moyen de simplifier $EXP(jk \, \Omega_0 T)$ lorsque $\Omega_0 Ts = (N + \epsilon ).2. \, \pi$ , avec $\epsilon$ de l'ordre de 1/100 ou -1/100, consiste à réaliser $\Omega_0 T = N.2. \, \pi$, c'est-à-dire à utiliser un retard pratique T très légèrement différent de $T_s$ , la dégradation des performances n'étant alors pas très sensible.

Mais ces solutions présentent divers inconvénients :

Dans la première solution on ne peut ajuster $\Omega_0 Ts$ qu'en réalisant un débit tramé supérieur au débit en ligne. Cette augmentation de débit est d'ailleurs usuelle dans le domaine des faisceaux hertziens numériques pour plusieurs raisons : pour permettre l'exploitation, pour ajouter des voies auxiliaires, en cas de présence d'un code correcteur d'erreurs entraînant une augmentation du débit, etc... Cependant il est souhaitable que cette augmentation de débit n'ait pas à satisfaire la condition $\Omega_0 Ts = N.2. \, \pi$ , qui est très contraignante, car n'offrant au mieux dans les cas pratiques qu'une possibilité pour $T_s$.

La deuxième solution n'est envisageable que dans des cas assez spécifiques : par exemple débits tramés très proches de 140 Mbit/s pour des modulations multi-états MAQ 16 ( ou 16 QAM "Quadrature Amplitude modulation" 16 états) ou MAQ 64, ou MAQ 256 et des fréquences intermédiaires de 70 ou 140 MHz (on a alors N = 2, 3, 4, 6, ou 8). De plus les performances sont légèrement dégradées par rapport à l'optimum.

Le but de la présente invention est de pouvoir avoir $\Omega_0$ et Ts indépendants entre eux tout en utilisant la simplicité du dernier algorithme donnant $C_k{}^{i+1}$.

L'invention consiste à utiliser des déphaseurs large bande 17 qui compensent les termes en $EXP(-jk \, \Omega_0 T)$ dans l'expression de Sc(t) ; chaque déphaseur 17 étant associé en série avec une cellule retard 12 tel que représenté à la figure 2.

$\Delta \phi$ est un déphaseur large bande tel que : $EXP(j \Delta \phi ) = EXP(j \Omega_0 Ts)$, c'est-à-dire tel que $\Delta \phi = \Omega_0 Ts$ [modulo $2 \pi$].

le signal en bande de base s'écrit alors :

$$Zc(t) = \sum_{k=-M}^{+L} C_k.Zr(t-kTs)$$

et l'algorithme de contrôle des coefficients :

$$C_k^{i+1} = C_k^i - \mu.\text{sgn}(\hat{E}_i).\text{sgn}(D_{i-k}^*)$$

est alors d'une réalisation aisée.

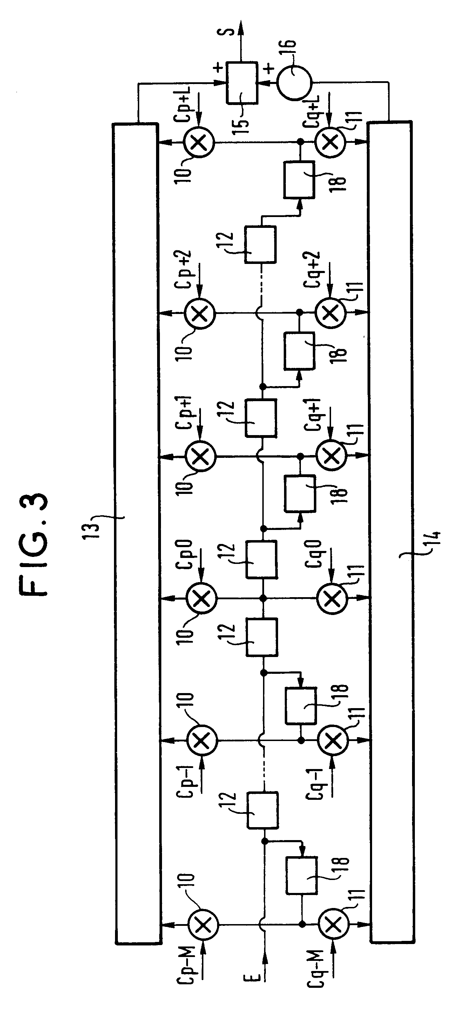

Un deuxième exemple de réalisation est représenté à la figure 3 : les cellules retard 12 sont toujours disposées en série, mais elles sont reliées aux points milieux des différentes branches d'indices i par des déphaseurs 18 de valeur $i \Delta \phi$ , chaque déphaseur $i \Delta \phi$ étant relié à la branche d'indice i, avec $-M \leq i \leq + L$.

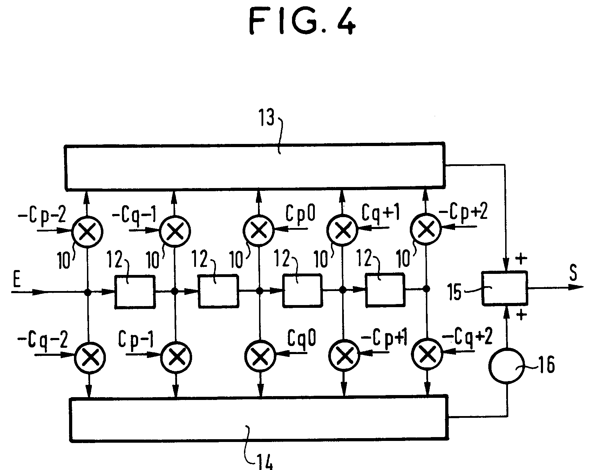

Cette réalisation, à priori plus compliquée, a un grand intérêt pratique lorsque $\Omega_0.Ts = 0$ [modulo $\frac{\pi}{2}$], on peut alors exploiter le déphaseur $\pi/2$ qui fait déjà partie du montage. Un exemple pratique d'une telle réalisation est donné à la figure 4, dans le cas d'un égaliseur où $M = L = 2$ et $\Omega_0.Ts = -\pi/2$ [modulo $2\pi$].

On voit que les coefficients phase (Cp) et quadrature (Cq) peuvent alors, soit rester sur leur branche d'origine avec éventuellement une modification de signe, soit être amenés à passer sur la branche en quadrature avec éventuellement une modification de signe. Les déphasages de $\pi/2$, $-\pi/2$, $\pi$ , etc... sont ainsi réalisables d'une manière particulièrement simple et séduisante.

Le filtre est alors tel que la branche d'indice -2 a un premier coefficient $-Cp_{-2}$ et un second coefficient $-Cq_{-2}$ ; la branche d'indice -1 a un premier coefficient $-Cq_{-1}$ et un second coefficient $-Cp_{-1}$ ; la branche d'indice $+1$ a un premier coefficient $Cq_{+1}$ et un second coefficient $-Cp_{+1}$, et la branche d'indice $+2$ a un premier coefficient $-Cp_{+2}$ et un second coefficient $-Cq_{+2}$.

Il importe de noter que cette solution est aussi très intéressante pratiquement lorsque la valeur de $\Omega_0.Ts$ est voisine de 0 [modulo $\frac{\pi}{2}$].

Parmi les filtres transverses on distingue les filtres récursifs qui possèdent un ou plusieurs rebouclages et sont donc à réponse impulsionnelle infinie et les filtres non récursifs qui, dépourvus de rebouclage, ont une réponse impulsionnelle finie.

Une filtre transverse ayant une partie directe et une partie récursive est décrite dans l'article, préalablement cité, de O. de Luca intitulé "Egaliseurs auto-adaptatifs en bande de base pour faisceaux hertiziens numériques (à la page 138).

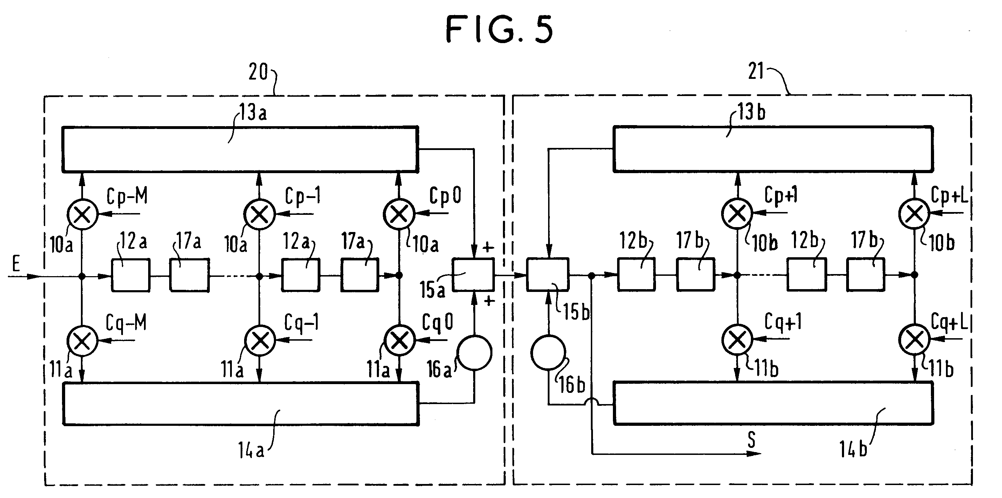

On peut réaliser un tel filtre transverse en mettant en oeuvre le filtre de l'invention. Ainsi la figure 5 représente un filtre avec une partie avant transverse 20 et une partie arrière récursive 21. Ce filtre reprend les mêmes éléments que celui représenté à la figure 2, les éléments de la partie avant transverse ayant un indice a, et ceux de la partie arrière récursive un indice b.

Ainsi la partie récursive 21 a une partie directe dont le signal est retardé successivement dans N cellules 12b à retard T, associée chacune à un déphaseur 17b. On reboucle alors la somme pondérée de ces signaux retardés sur un sommateur d'entrée 15b.

Il est bien entendu que la présente invention n'a été décrite et représentée qu'à titre d'exemple préférentiel et que l'on pourra remplacer ses éléments constitutifs par des éléments équivalents sans, pour autant sortir du cadre de l'invention.

Ainsi le filtre transverse de la figure 5, qui a une partie directe et une partie recursive, pourrait tout aussi bien être basé sur les filtres représentés en figures 3 et 4.

**Revendications**

1. Filtre transverse comportant $M + L + 1$ branches comprenant chacune de part et d'autre d'un point milieu un premier multiplieur (10) par un premier coefficient et un second multiplieur (11) par un second coefficient, chaque branche étant relié à ses deux extrémités respectivement à un premier sommateur (13) et à un second sommateur (14), et $M + L$ cellules de retard (12) en série, chacune d'elle étant reliée au point milieu de l'une des branches, caractérisé en ce qu'un déphaseur large bande (17), dont le déphasage $\Delta \phi$ tel que $\Delta \phi = \Omega_0 T$ (modulo $2\pi$), où $\Omega_0$ est la pulsation porteuse en fréquence intermédiaire et T représente la durée de retard dû à une cellule retard (12), est associé en série avec chaque cellule retard (12).

2. Filtre selon la revendication 1, caractérisé en ce que le retard T est égal au retard symbole Ts.

3. Filtre selon l'une quelconque des revendications 1 ou 2, caractérisé en ce que chaque cellule retard (12) est reliée au point milieu d'une branche d'indice i par un déphaseur dont la valeur de déphasage est $i\Delta\phi$ avec $-M \leq i \leq + L$.

**4.** Filtre selon l'une quelconque des revendications précédentes, caractérisé en ce que $\Omega$ oT $= \pi /2$ ou $-\pi/2$ (modulo 2 $\pi$).

**5.** Filtre selon la revendication 4, caractérisé en ce que M = L = 2, $\Omega$oT = $- \pi /2$ (modulo 2 $\pi$), et en ce que la branche d'indice -2 a un premier coefficient $-Cp_{-2}$ et un second coefficient $-Cq_{-2}$ ; la branche d'indice -1 a un premier coefficient $-Cq_{-1}$ et un second coefficient $Cp_{-1}$ ; la branche d'indice +1 a un premier coefficient $Cq_{+1}$, et un second coefficient $-Cp_{+1}$ ; et la branche d'indice +2 a un premier coefficient $-Cp_{+2}$ et un second coefficient $-Cq_{+2}$.

**6.** Filtre selon l'une quelconque des revendications précédentes, caractérisé en ce qu'il comprend une partie avant transverse (20) et une partie arrière récursive (21).

**Claims**

**1.** A transversal filter comprising: M + L + 1 branches each having a midpoint connected to first and second multipliers for multiplication by respective first and second coefficients; and each branch being connected at its ends to respective first and second summing circuits, and the filter comprising a series connection of M + L delay lines each one connected respectively to the midpoint of one of said branches, characterized in that a wideband phase shifter (17) is associated in series with each delay cell (12), said phase shifter providing a phase shift $\delta\phi$ such that $\delta\phi = \Omega_0 T$ (modulo $2\pi$) where $\Omega_0$ is the angular frequency of the intermediate carrier and T represents the duration of the delay due to one delay cell (12).

**2.** A filter according to claim 1, characterized in that the delay T is equal to the symbol time Ts.

**3.** A filter according to claim 1 or 2, characterized in that each delay cell (12) is connected to the midpoint of a branch of index i by a phase shifter providing a phase shift of value $i\delta\phi$, where -M $\leq$ i $\leq$ +L.

**4.** A filter according to any preceding claim, characterized in that $\Omega_0 T = \pi/2$ or $-\pi/2$ (modulo $2\pi$).

**5.** A filter according to claim 4, characterized in that M = L = 2, $\Omega_0 = -\pi/2$ (mod $2\pi$), and the branch of index -2 has a first coefficient $-Cp_{-2}$ and a second coefficient $-Cq_{-2}$; the branch of index -1 has a first coefficient $-Cq_{-1}$ and a second coefficient $Cp_{2-1}$; the branch of index +1 has a first coefficient $Cq_{+1}$ and a second coefficient $-Cp_{+1}$; and the branch of index +2 has a first coefficient $-Cp_{+2}$ and a second coefficient $-Cq_{+2}$.

**6.** A filter according to any preceding claim, characterized in that it includes a leading transversal portion (20) and a trailing recursive portion (21).

**Patentansprüche**

**1.** Transversalfilter mit M + L + 1 Zweigen, die je zu beiden Seiten eines Mittelpunkts einen ersten Multiplizierer (10) zum Multiplizieren mit einem ersten Faktor und einen zweiten Multiplizierer (11) zum Multiplizieren mit einem zweiten Faktor besitzen, wobei jeder Zweig mit seinen beiden Enden mit einem ersten Summierer (13) bzw einem zweiten Summierer (14) verbunden ist und wobei das Transversalfilter weiter M + L Verzögerungszellen (12) in Reihe enthält, die je mit dem Mittelpunkt eines der Zweige verbunden sind, dadurch gekennzeichnet, daß jeder Verzögerungszelle (12) in Reihe ein Breitbandphasen` schieber (17) zugeordnet ist, dessen Phasenverschiebung $\Delta\phi$ so gewählt ist, daß $\Delta\phi = \Omega_0 T$[modulo $2\pi$] ist, wobei $\Omega_0$ die Trägerzwischenfrequenz im Zwischenfrequenzbereich ist und T die Verzögerungsdauer aufgrund einer Verzögerungszelle (12) ist.

**2.** Filter nach Anspruch 1, dadurch gekennzeichnet, daß die Verzögerungszeit T gleich der Verzögerung Ts eines Symbols ist.

**3.** Filter nach einem beliebigen der Ansprüche 1 oder 2, dadurch gekennzeichnet, daß jede Verzögerungszelle (12) an den Mittelpunkt eines Zweigs mit dem Index i über einen Phasenschieber angeschlossen ist, dessen Wert der Phasenverschiebung gleich $i\Delta\phi$ gewählt ist, wobei -M $\leq$ i $\leq$ +L gilt.

4.  Filter nach einem beliebigen der vorhergehenden Ansprüche, dadurch gekennzeichnet, daß gilt: $\Omega_0 T = \pi/2$ oder $-\pi/2$ [modulo $2\pi$].

5.  Filter nach Anspruch 4, dadurch gekennzeichnet, daß $M = L = 2$ und $\Omega_0 = -\pi/2$ (modulo $2\pi$) und daß der Zweig mit dem Index -2 einen ersten Koeffizienten $-Cp_{-2}$ und einen zweiten Koeffizienten $-Cq_{-2}$ besitzt, während der Zweig mit dem Index -1 einen ersten Koeffizienten $-Cq_{-1}$ und einen zweiten Koeffizienten $Cp_{-1}$ sowie der Zweig mit dem Index +1 einen ersten Koeffizienten $Cq_{+1}$ und einen zweiten Koeffizienten $-Cp_{+1}$ und der Zweig mit dem Index +2 einen ersten Koeffizienten $-Cp_{+2}$ und einen zweiten Koeffizienten $-Cq_{+2}$ besitzt.

6.  Filter nach einem beliebigen der vorhergehenden Ansprüche, dadurch gekennzeichnet, daß es einen vorderen Transversalteil (20) und einen hinteren Rekursivteil (21) besitzt.

7

# FIG.1

# FIG.2

FIG.3

# FIG. 4

# FIG. 5

EP 0 327 966 B1